# EUROPEAN PATENT APPLICATION

(11) **EP 3 477 714 A1**
(43) Date of publication of application: **01.05.2019**
(21) Application number: 17199108.6
(22) Date of filing: 30.10.2017
(51) Int. Cl.: H01L 35/32

(54) **PORTABLE ELECTRONIC DEVICE**

(71) Applicant: Vestel Elektronik Sanayi ve Ticaret A.S., 45030 Manisa (TR)
(72) Inventor: EFE, Mesut, 45030 Manisa (TR)
(74) Representative: Thomas, Michael Andrew

(57) **Abstract**

A portable electronic device (10) is provided having a casing (12) enclosing an electronic circuit (14), a rechargeable battery (16) and a thermoelectric structure (22) disposed between the electronic circuit (14) and an external surface of the portable electronic device. The thermoelectric structure (22) has a first surface (24) in proximity to the electronic circuit (14) and a second surface (26) in thermal contact with the exterior of the portable electronic device. The thermoelectric structure (22) is configured to supply a thermoelectric current, when generated, for use in providing a supplementary source of power to the portable electronic device (10). The portable electronic device may be any of the known portable electronic devices including for example mobile phones, MP3 players, personal computing devices, digital cameras and GPS navigation devices.

## Description

### Technical Field

The present disclosure relates to portable electronic devices.

### Background

Provision of adequate battery capacity in mobile phones and other types of portable electronic device remains a challenge. Various types of portable energy source are known for providing supplementary power to recharge batteries or portable electronic devices when remote from a permanent power source, including stored energy devices and energy generating devices. Of the known energy generating devices, there are a number of devices making use of thermoelectric elements to generate electricity. Such devices are self-contained and may be used to supply an electric current to supplement an existing power source in a range of portable electronic devices, including mobile phones, navigation aids, etc.

### Summary

According to a first aspect disclosed herein, there is provided a portable electronic device having a casing enclosing an electronic circuit, a rechargeable battery and a thermoelectric structure disposed between the electronic circuit and an external surface of the device, the thermoelectric structure having a first surface disposed to receive heat from the electronic circuit (14), in use, and a second surface in thermal contact with the exterior of the device, wherein the thermoelectric structure is configured to supply a thermoelectric current, when generated, for use in providing a supplementary source of power to the device.

Inclusion of a thermoelectric structure within a portable electronic device enables the energy consumption of the device to be reduced with the benefit that a longer period of operation may be enjoyed from a given battery capacity.

In an example, the thermoelectric structure is enclosed by the casing.

Alternatively, the thermoelectric structure is integrated with the casing to provide a portion of an exterior surface of the portable electronic device.

In an example, the thermoelectric structure is connected to a power management component of the portable electronic device. The power management component may use the electric current supplied by the thermoelectric structure in the most efficient way according to a use being made of the portable electronic device.

In an example, the thermoelectric structure comprises an arrangement of dissimilar electrically conducting materials of a first and a second type, wherein one or more portions of the first and second types of material extend between the first face and the second face of the structure, a portion of the first type of material being electrically coupled at the first face to a portion of the second type of material and the portions being electrically connected directly or indirectly to a power management component of the portable electronic device.

In an example, the first type of material is a *p*-type semiconductor and the second type of material is an *n*-type semiconductor.

In an example, two or more pairs of portions of the first and second types of material are connected in series at the second face.

Alternatively or in addition, two or more pairs of portions of the first and second types of material are connected in parallel at the second face. The configuration of series-connected or parallel connected elements of the thermoelectric structure may be determined according to a required supply voltage of the portable electronic device.

In an example, the portable electronic device may comprise any one of: a mobile phone; an MP3 player; a personal computer; a digital camera; and a GPS-based navigation device.

### Brief Description of the Drawings

To assist understanding of the present disclosure and to show how embodiments may be put into effect, reference is made by way of example to the accompanying drawings in which:
Figure 1 shows schematically a sectional view of an example portable electronic device, in this example a mobile phone, according to the present disclosure;
Figure 2 shows schematically a sectional view of another example mobile phone according to the present disclosure; and
Figure 3 shows schematically a sectional view of an example thermoelectric structure as may be used in a portable electronic device such as the mobile phone of Figure 1 or Figure 2, according to the present disclosure.

### Detailed Description

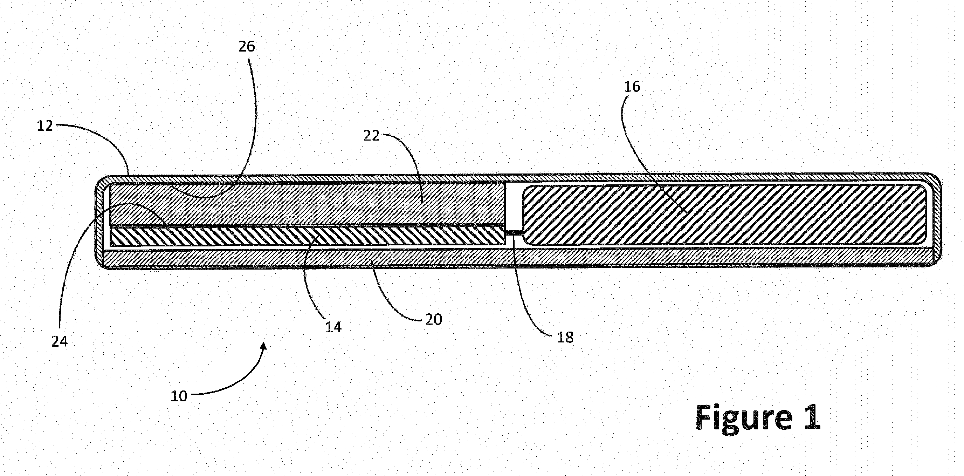

In a particular example to be described below with reference to Figure 1, a mobile phone device is provided with a thermoelectric structure built into the phone. The thermoelectric structure enables heat generated by components of the phone's electronic circuit, and thereby a temperature difference between that and the ambient temperature outside the phone, to be exploited to generate an electric current. The electric current may be used to provide a supplementary source of power to the phone. In this way the overall energy consumption of the phone may be reduced and its period of use for a given battery capacity may be extended. The supplementary source of power to the may be used to charge a rechargeable battery of the device.

As would be apparent to a person of ordinay skill in the relevant art, other types of portable electronic device may be provided with a thermoelectric structure according to the present disclosure, configured as for the mobile phone example mentioned above, to provide a supplementary source of power to the device or for use in charging a rechargeable battery of the device. Such portable electronic devices may include for example MP3 players, a portable personal computer of any of the available types including tablet devices, digital books etc., digital cameras and GPS navigation devices.

Referring to Figure 1, a schematic sectional view is provided of an example of a mobile phone 10 according to the present disclosure. The phone 10 has a casing 12 in which is contained an electronic circuit 14 of the phone 10 and a rechargeable battery 16. The battery 16 is connected by a connection 18 to supply electrical power to the circuit 14. The casing 12 also supports a display screen 20.

The mobile phone 10 differs from conventional mobile phones in having a thermoelectric structure 22 built into the phone between the electronic circuit 14 and the casing 12. The thermoelectric structure 22 has a first face 24 in thermal contact with, for example by being in physical contact with or in close proximity to the electronic circuit 14 so that any heat generated by components of the electronic circuit 14 causes a corresponding temperature rise at the first face 24 of the thermoelectric structure 22. The thermoelectric structure 22 has a second face 26 in thermal contact with, for example by being in physical contact with or in close proximity to the casing 12 which, in general use, will be exposed to ambient temperatures.

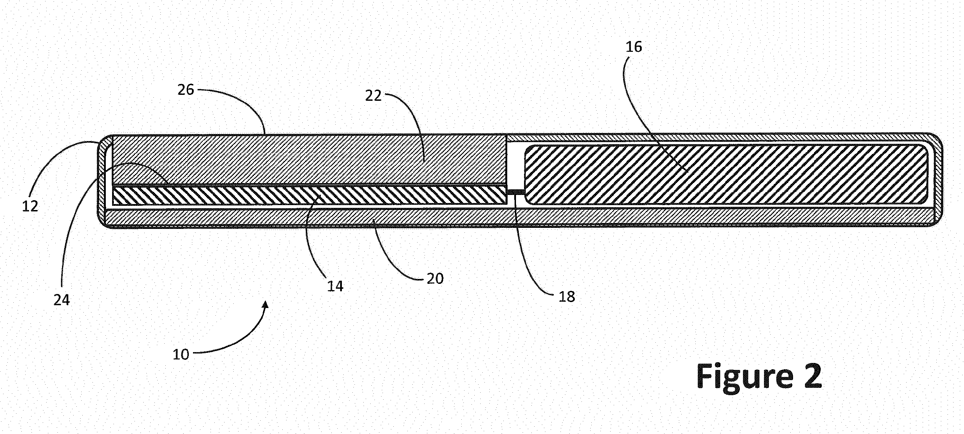

The thermoelectric structure 22 may alternatively be integrated as a part of the casing 12 or mounted within an aperture in the casing 12 such that the second surface 26 of the thermoelectric structure 22 forms a part of the exterior surface of the phone 10. This variant is shown in Figure 2.

Any temperature difference between the first, so-called 'hot' surface 24 of the thermoelectric structure 22 and the second, so-called 'cold' surface 26 of the thermoelectric structure 22, causes an electromotive force (emf) to be generated and hence an electric current to flow through the structure 22 when the structure 22 is connected to a load. This electric current may be connected and supplied for use in or by a power management component of the phone 10 to supplement the power provided to the electronic circuit 14 by the battery 16 or, for example, to recharge the battery 16.

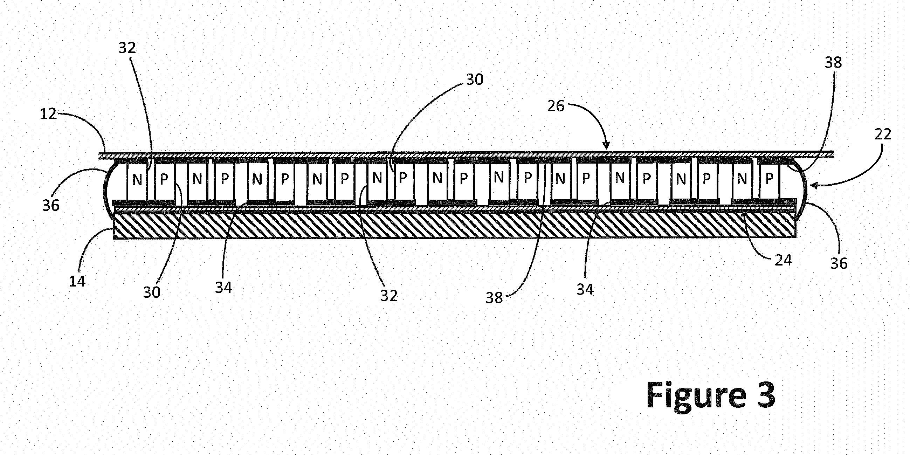

The thermoelectric structure 22 may be one of a number of known structures arranged to exploit the thermoelectric properties of dissimilar conductors. One example structure will now be described with reference to Figure 3.

Referring to Figure 3, an example thermoelectric structure 22 is shown in a schematic sectional view of a part of the phone 10, located between and in contact with the electronic circuit 14 and the casing 12. The thermoelectric structure 22 comprises a structure formed of portions, in this example in the form of substantially rectangular blocks 30, 32, of dissimilar semiconductor materials. The blocks 30, 32 are fabricated to comprise an arrangement of *p*-type semiconductor blocks 30 and *n*-type semiconductor blocks 32. The blocks 30, 32 are arranged in pairs, each pair comprising one block formed of each type of semiconductor material. The blocks 30, 32 in each pair are electrically coupled at the 'hot' face 24 of the structure 22 to form a 'hot' junction by respective electrodes 34. At the 'cold' face 26 of the structure 22, one block 30, 32 of each pair is electrically connected either to a respective conducting link 36 or to one block 30, 32 of an adjacent pair by a respective electrode 38. The links 34 connect the structure 22 to the power management component of the phone 10, for example.

Pairs of the blocks 30, 32 may be connected in series, as shown in Figure 3 for the sectional view provided, to increase the thermoelectric voltage generated by the structure 22, or in parallel to increase the thermoelectric current. If connected in series, as in the section shown in Figure 3, the *p*-type semiconductor block 30 of one pair is connected by the electrode 38 to the *n*-type semiconductor block 32 of an adjacent pair. If connected in parallel, the *p*-type and *n*-type semiconductor blocks 30, 32 of one pair are connected respectively by electrodes 38 to the *p*-type and *n*-type semiconductor blocks 30, 32 of an adjacent pair.

In operation, heat generated by components of the electronic circuit 14 causes a temperature difference between the junction at the 'hot' face 24 of the structure 22 and the 'cold' face 26. According to the Seebeck Effect, the temperature difference causes a corresponding voltage to be developed between the dissimilar conductors of each pair of blocks 30, 32 at the 'cold' face 26 of the structure 22. As a result, in this example, an electric current flows through each pair of semiconductor blocks 30, 32 via the 'hot' junction electrode 34 when the 'cold' face electrodes 38 are coupled to an external load, such as the rechargeable battery 16. In the arrangement shown in Figure 3, at each end of an interconnected series of pairs of semiconductor blocks 30, 32 the links 36 connect respective electrodes 38 of the thermoelectric structure 22 to a power management component of the phone 10, included for example as a part of the electronic circuit 14.

Other types of dissimilar conductor material (not limited to semiconductor materials for example) may be selected to form the thermoelectric structure 22, with differing levels of capability to generate electrical current, according to the Seebeck coefficients of the conductors used. Furthermore, other arrangements of dissimilar conductors, as would be apparent to a person skilled in the relevant art, may be fabricated to generate a required thermoelectric voltage and to cause a flow of thermoelectric current from the structure 22.

The examples described herein are to be understood as illustrative examples of embodiments of the invention. Further embodiments and examples are envisaged. Any feature described in relation to any one example or embodiment may be used alone or in combination with other features. In addition, any feature described in relation to any one example or embodiment may also be used in combination with one or more features of any other of the examples or embodiments, or any combination of any other of the examples or embodiments. Furthermore, equivalents and modifications not described herein may also be employed within the scope of the invention, which is defined in the claims.

## Claims

1. A portable electronic device (10) having a casing (12) enclosing an electronic circuit (14), a rechargeable battery (16) and a thermoelectric structure (22) disposed between the electronic circuit (14) and an external surface of the device, the thermoelectric structure (22) having a first surface (24) disposed to receive heat from the electronic circuit (14), in use, and a second surface (26) in thermal contact with the exterior of the device, wherein the thermoelectric structure (22) is configured to supply a thermoelectric current, when generated, for use in providing a supplementary source of power to the device(10).

2. The portable electronic device (10) according to claim 1, wherein the thermoelectric structure (22) is enclosed by the casing (12).

3. The portable electronic device (10) according to claim 1, wherein the thermoelectric structure (22) is integrated with the casing (12) to provide a portion of an exterior surface of the portable electronic device (10).

4. The portable electronic device (10) according to any one of claims 1 to 3, wherein the thermoelectric structure (22) is connected to a power management component of the portable electronic device (10).

5. The portable electronic device (10) according to any one of claims 1 to 4, wherein the thermoelectric structure (22) comprises an arrangement of dissimilar electrically conducting materials of a first and a second type, wherein one or more portions (30, 32) of the first and second types of material extend between the first face (24) and the second face (26) of the structure (22), a portion (30) of the first type of material being electrically coupled at the first face to a portion (32) of the second type of material and said portions (30, 32) being electrically connected (38, 36) directly or indirectly to a power management component of the portable electronic device (10).

6. The portable electronic device e (10) according to claim 5, wherein the first type of material is a *p*-type semiconductor and the second type of material is an *n*-type semiconductor.

7. The portable electronic device (10) according to claim 5 or claim 6, wherein two or more pairs of portions (30, 32) of the first and second types of material are connected (38) in series at the second face (26).

8. The portable electronic device (10) according to any one of claims 5 to 7, wherein two or more pairs of portions (30, 32) of the first and second types of material are connected (38) in parallel at the second face (26).

9. The portable electronic device (10) according to any one of claims 1 to 8, comprising any one of: a mobile phone; an MP3 player; a personal computer; a digital camera; and a GPS-based navigation device.
